Europäisches Patentamt

European Patent Office

Office européen des brevets

(19)

(11) Numéro de publication : **0 188 151**
**B1**

(12) **FASCICULE DE BREVET EUROPÉEN**

(45) Date de publication du fascicule du brevet :
28.03.90

(51) Int. Cl.⁵ : **H 03 M 11/00**

(21) Numéro de dépôt : **85402460.1**

(22) Date de dépôt : **10.12.85**

(54) **Dispositif de commande par touches.**

(30) Priorité : **20.12.84 FR 8419514**

(43) Date de publication de la demande :
**23.07.86 Bulletin 86/30**

(45) Mention de la délivrance du brevet :
**28.03.90 Bulletin 90/13**

(84) Etats contractants désignés :
**DE GB IT**

(56) Documents cités :
**DE—A— 2 815 234**
**ELEKTRONIK, vol. 27, no. 11, octobre 1978, page 112,**
**Munich, DE; E. STEINER: "Tastaturanschluss"**

(73) Titulaire : **AUTOMOBILES PEUGEOT, Société dite:**
**75, Avenue de la Grande-Armée**
**F-75761 Paris Cedex 16 (FR)**

**AUTOMOBILES CITROEN**
**62 Boulevard Victor-Hugo**
**F-92200 Neuilly-sur-Seine (FR)**

(72) Inventeur : **Herbault, Patrick Jean-Pierre**
**94, rue Thiers**
**F-92100 Boulogne-Billancourt (FR)**
Inventeur : **Bosc, Jean-Jacques Alain Louis**
**7, rue Frédéric Chopin Res. "Les Peupliers"**
**F-91380 Chilly-Mazarin (FR)**

(74) Mandataire : **Fabien, Henri**
**PEUGEOT SA. DAT / BPI 18, rue des Fauvelles**
**F-92250 La Garenne-Colombes (FR)**

EP 0 188 151 B1

## Description

L'invention concerne un dispositif de commande par touches du type dans lequel les touches ferment, lorsqu'elles sont pressées, un contact entre des conducteurs reliés aux entrées/sorties d'un micro-ordinateur ou d'une logique câblée respectivement programmée ou agencée pour scruter l'état des touches, ces conducteurs étant constitués de M colonnes et de N lignes aux intersections desquelles sont situées les touches et les contacts associés.

Comme décrit par exemple dans le document ELEKTRONIK, vol. 27, no. 11, octobre 1978, page 112, Munich, DE ; E. Steiner : « Tastaturanschluss », dans les dispositifs de ce type les colonnes et les lignes sont généralement chacune reliées à une entrée/sortie ce qui mobilise M + N entrées/sorties, l'une d'elles pouvant éventuellement être remplacée par la mise à la masse d'une colonne ou d'une ligne.

L'invention a pour objet un dispositif de commande par touches perfectionné de manière à minimiser le nombre d'entrées/sorties mobilisées pour le décodage et par conséquent à maximiser celles qui restent disponibles pour d'autres usages.

Un dispositif selon l'invention est caractérisé en ce qu'au moins une colonne n'est reliée à une entrée/sortie que par une ligne avec interposition d'une diode entre la colonne et la ligne, l'intersection de cette colonne et de cette ligne ne comportant pas de touche et de contact associé.

De préférence le dispositif comporte des moyens de rappel de l'état logique des lignes reliées au colonne à un même état logique toujours le même en l'absence d'autre sollicitation.

Le programme de scrutation du micro-ordinateur ou de la logique câblée équivalente comporte de préférence les phases suivantes :

— Configuration successive de chaque entrée/sortie dans la fonction (sortie) inhibant l'action des moyens de rappel (R) pour cette entrée/sortie, les autres entrées/sorties étant configurées dans la fonction inverse (entrée).

— Mise à O (ou à son complément) de la ligne testée et mémorisation de l'état logique des lignes.

— Comparaison de l'état mémorisé et de l'état correspondant à l'absence de touche enfoncée.

— Mémorisation du résultat (Z) de la comparaison.

— Si le résultat (Z) indique une touche enfoncée, établissement d'un code de l'état des touches et comparaison avec un tableau de codes valides.

Le code est avantageusement constitué d'une combinaison de l'état mémorisé et de l'état correspondant à l'absence de touche enfoncée.

On peut en outre prévoir une colonne supplémentaire reliée à des moyens de rappel vers l'état logique opposé à l'état logique de rappel des lignes.

Dans ce cas le programme de scrutation comporte une boucle préliminaire au cours de laquelle la colonne supplémentaire est testée.

Enfin les moyens de rappel de l'état logique des lignes peuvent être avantageusement constitués en reliant à travers des résistances les entrées/sorties à l'alimentation positive du micro-ordinateur ou de la logique câblée. Dans ce cas la colonne supplémentaire est reliée à la masse.

On a décrit ci-après un exemple de réalisation de l'invention sous forme de clavier à touches utilisant un micro-ordinateur, avec référence aux dessins annexés dans lesquels :

La figure 1 est une vue schématique de l'ensemble du micro-ordinateur et du câblage des touches du clavier qui comporte 16 touches.

La figure 2 représente les relations logiques entre les lignes du clavier et les registres d'entrée/sortie dont 4 sont affectées à la gestion du clavier.

La figure 3 est un tableau des valeurs hexadécimales attribuées aux touches.

La figure 4 est un organigramme du programme principal.

La figure 5 est un organigramme du sous-programme TOUCHE.

La figure 6 est le tableau des codes valides.

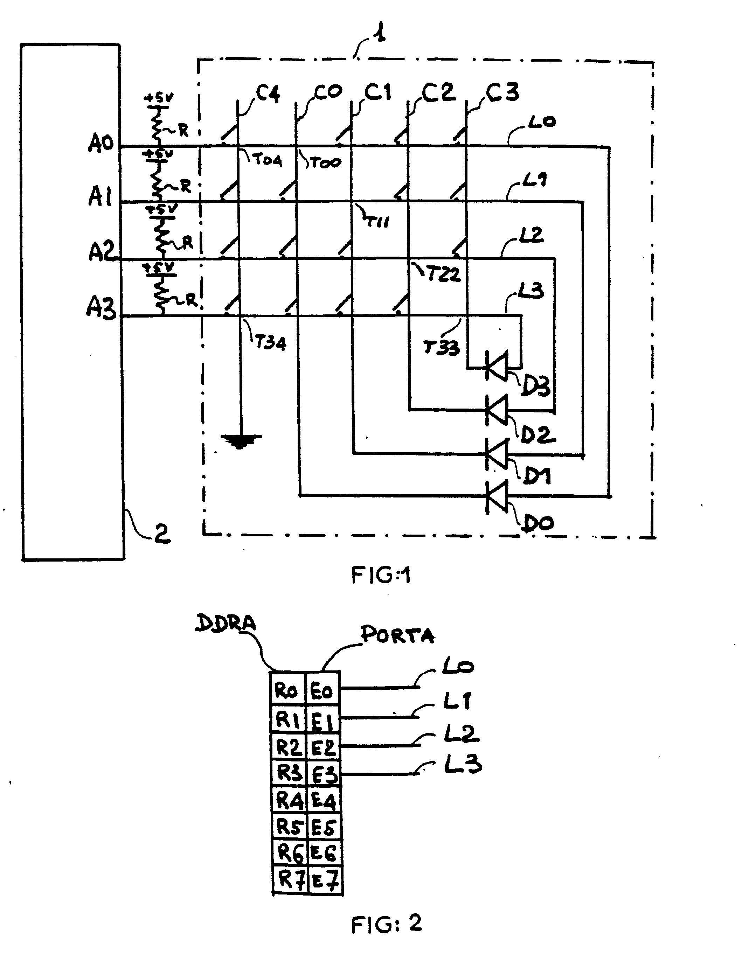

Le clavier 1 (figure 1) comporte 16 touches et le micro-ordinateur 2 est du type 6805P2 commercialisé en France par THOMSON-EFCIS.

L'invention permet de ne mobiliser pour la scrutation des touches que 4 entrées/sorties du micro-ordinateur. Les entrées/sorties utilisées sont les 4 entrées/sorties de poids faible (A0 à A3) du port A (figure 2).

Le registre du port A et le registre directeur des données qui lui est associé sont respectivement symbolisés PORTA (bits E0 à E7) et DDRA (bits R0 à R7).

Des touches TIJ et leur contact associé sont disposés à chaque intersection de lignes LI et de colonnes CJ sauf pour les intersections de rang I égal à J. Les lignes L0 à L3 sont chacune respectivement connectées par l'une de leurs extrémités aux entrées/sorties A0 à A3 et par leur extrémité opposée aux colonnes CO à C3 avec interposition d'une diode D0 à D3. En outre les lignes L0 à L3 sont connectées à travers une résistance R à l'alimentation + 5V et sont ainsi ramenées à l'état logique 1 en l'absence d'autre sollicitation.

Une colonne supplémentaire C4 est reliée en permanence à la masse et comporte 4 touches (T04 à T34) à l'intersection des lignes L0 à L3 remplaçant les 4 touches manquantes de la diagonale de la matrice 4 × 4.

Le tableau de la figure 3 indique les valeurs hexadécimales affectées aux intersections des lignes et des colonnes (de $00 à $0F).

On va maintenant exposer le principe de scrutation. On teste d'abord l'état des touches de la colonne C4 reliée à la masse en mettant en entrée les lignes L0 à L3. Il suffit pour cela de mettre à 0 les bits R0 à R3 du registre directeur de données DDRA. On met ensuite à 0 les bits E0 à E3 du registre PORTA. Le montage « pull-up » sur les entrées/sorties ramène à l'état 1 les bits E0 à E3 sauf ceux correspondant à une ligne mise à la masse par la pression d'une touche de la colonne C4.

On teste ensuite chaque ligne LI pour détecter l'enfoncement d'une touche située aux intersections de cette ligne avec les colonnes C0 à C3 en mettant en sortie la ligne LI, les autres lignes étant en entrée (bit RI mis à 1 et les autres bits de DDRA mis à 0). Comme précédemment on met alors à 0 les bits E0 à E3 du registre PORTA. Le bit EI reste à 0 (ligne LI conformée en sortie) et les autres bits son ramenés à 1 par l'effet « pull-up » sauf ceux reliés par une diode DJ à une touche pressée de la ligne LI.

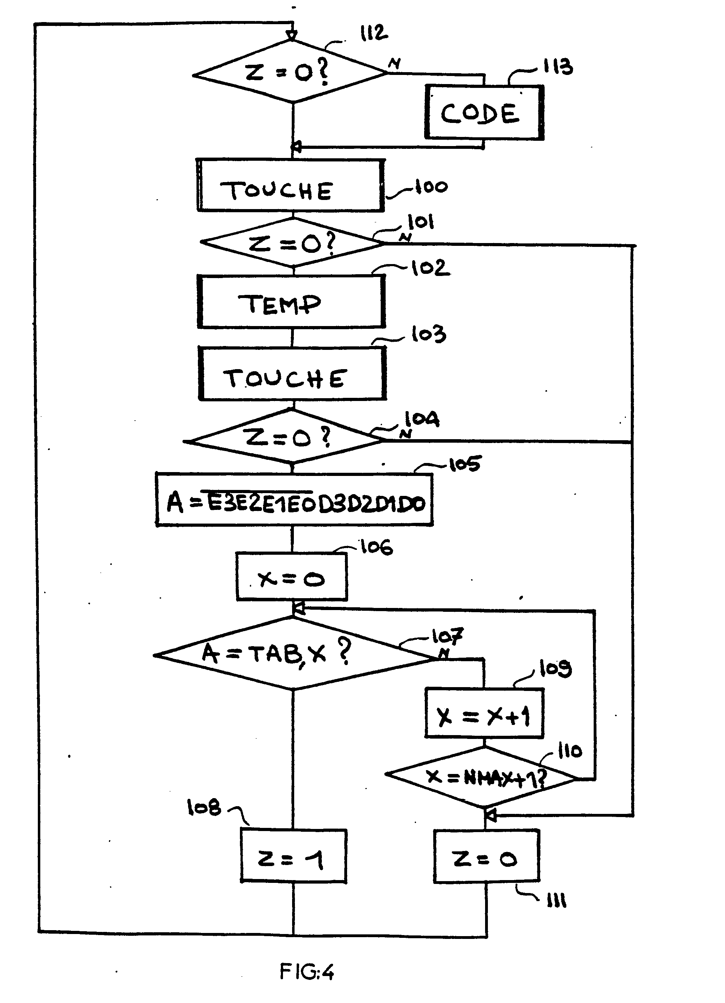

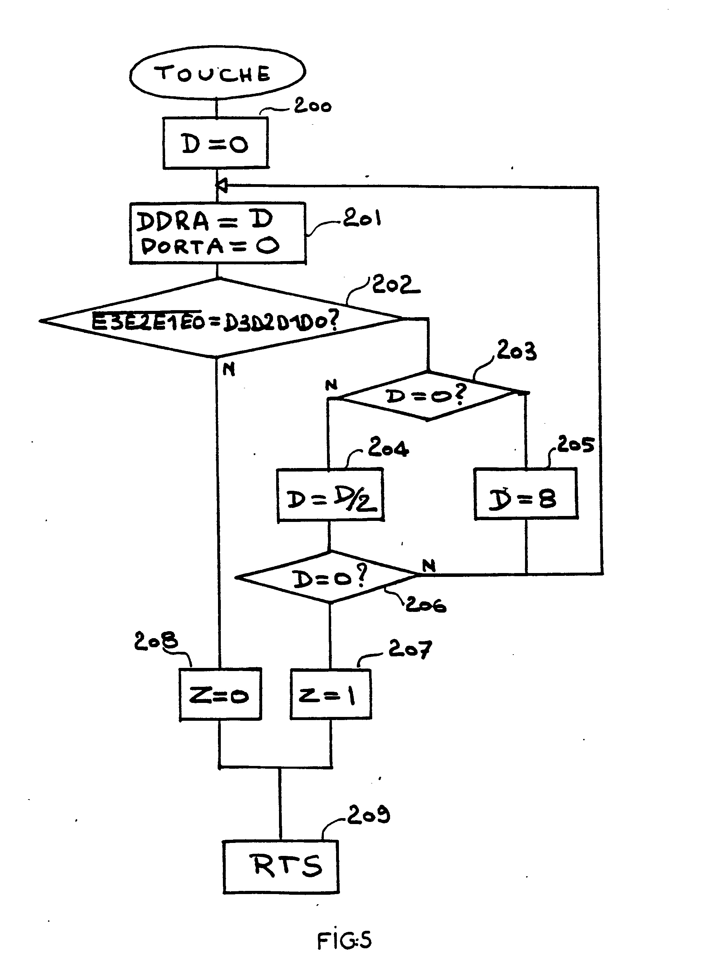

On se réfère maintenant aux figures 4 et 5 qui représentent respectivement les organigrammes du programme principal et du sous-programme TOUCHE.

La scrutation commence à l'étape 100 du programme principal où le sous-programme touche est appelé ; TOUCHE positionne à 0 le bit Z du registre d'état (ou registre codes conditions) du micro-ordinateur si une touche est enfoncée et à 1 dans le cas contraire.

Si Z = 1 (étape 101) l'exécution passe à l'étape 111 où le bit Z est mis à 0,

Si Z = 0, un sous-programme TEMP est exécuté (étape 102). Le sous-programme TEMP introduit simplement un délai de quelques millisecondes puis le sous-programme TOUCHE est à nouveau appelé (étape 103). Cette disposition protège contre les effets de rebond des touches.

Le bit Z est à nouveau testé (étape 104). Si Z = 1, il n'y a pas de touche pressée et l'exécution passe à l'étape 111.

Dans le cas contraire l'exécution se poursuit par les étapes 105 et suivantes dont le rôle sera exposé après avoir examiné l'organigramme du sous-programme TOUCHE.

Dans la première étape 200 du sous-programme TOUCHE, une variable mémoire D est initialisée à 0. Le registre directeur de données DDRA est chargé (étape 201) avec la valeur D et le registre $\overline{PORTA}$ est mis à 0. A l'étape 202 on compare $\overline{E3E2E1E0}$ à D3D2D1D0 les autres bits de PORTA et de DDRA étant masqués ce qui en utilisant les mnémoniques usuels du 6805 peut se faire de la façon suivante :

```
Etape 201    STA D        ; 0, 8, 4, 2, 1 dans D
             ORA # $F0
             STA DDRA
             LDA PORTA
             AND # $F0
             STA PORTA
             LDA PORTA
             ORA # $F0

Etape 202    COMA         ; E̅3̅E̅2̅E̅1̅E̅0̅ dans A
             CMP D
```

A l'étape 202 on compare $\overline{E3E2E1E0}$ à D3D2D1D0. S'il n'y a pas identité une touche est pressée et le bit Z est mis à 0 (étape 208). Dans le cas contraire on teste D (étape 203). Si D n'est pas nul on le divise par 2 (étape 204) par un décalage à droite.

Si D est nul on le met à 8 (étape 205) et on boucle sur l'étape 201. D prend donc successivement les valeurs binaires 1000 0100 0010 0001 et finalement 0.

Si D prend la valeur 0 après l'étape 204, le bit Z est mis à 1 (étapes 206-207) et on retourne au programme d'appel. Dans le cas contraire le branchement s'effectue à l'étape 201.

On voit donc qu'à l'étape 201 on a bien successivement mis les bits R0R1R2R3 de DDRA dans les états 0000 1000 0100 0010 0001 pour tester d'abord la colonne C4 puis successivement l'intersection de chaque ligne LI avec les colonnes C0 à C3.

On va maintenant décrire les étapes 105 et suivantes du programme principal. Z est positionné à 0 et l'accumulateur A contient $\overline{E3E2E1E0}$ comme bits de poids faible. On génère dans l'accumulateur le code $\overline{E3E2E1E0}D3D2D1D0$ en effectuant 4 décalages à gauche puis un OU logique de l'accumulateur avec la variable D retournée par le programme TOUCHE. Le code ainsi constitué est donc la combinaison des 4 bits de poids faible de $\overline{PORTA}$ et des 4 bits de poids faible de DDRA.

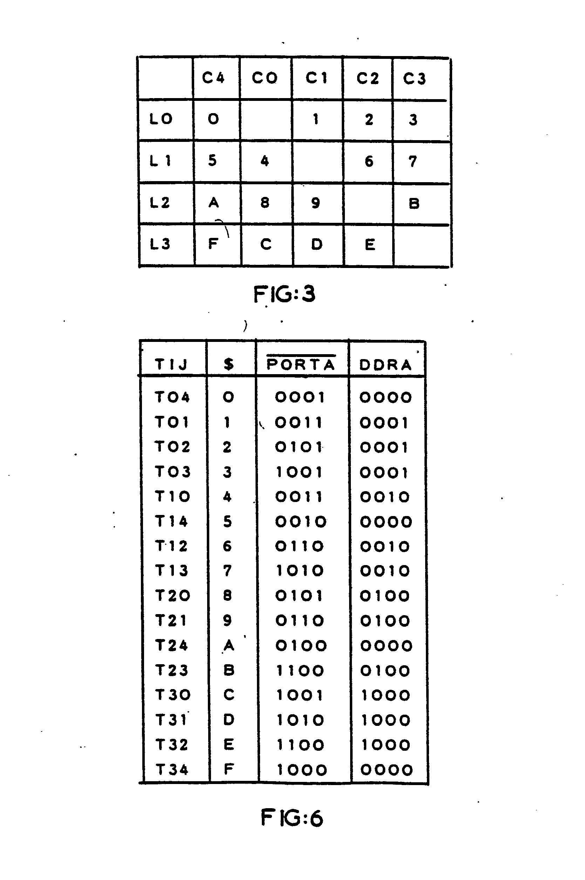

A l'étape 106 on initialise le registre index X à 0 et en 107 on compare le code A à l'élément de rang X d'un tableau de codes TAB (figure 6).

Tant que le code A n'a pas été trouvé on incrémente X jusqu'à la valeur maxi du tableau TAB et on boucle sur l'étape 107.

Si aucune comparaison n'a donné l'égalité le bit Z est mis à 0 en 111. Dans le cas contraire on sort avec le bit Z = 1 (étape 108) et la valeur du registre X représente le numéro d'ordre du code.

On résoud ainsi le problème des touches « fantôme » (cas d'un code ne figurant pas dans TAB si deux touches sont simultanément appuyées).

Le bit Z est testé à l'étape 112. Si Z est différent de 0 le sous-programme CODE est appelé, sinon la scrutation des touches est reprise à l'étape 100.

Le sous-programme CODE peut par exemple, en fonction des codes entrés au clavier, envoyer (ou recevoir) des informations en direction de périphériques branchés sur des entrées/sorties disponibles.

Bien entendu l'invention ne se limite pas au mode de réalisation décrit. C'est ainsi que le micro-ordinateur pourrait être remplacé par des circuits intégrés spécifiques de l'application ou tout autre combinaison équivalente de microprocesseur, boîtiers d'entrée/sortie et mémoires.

Par ailleurs les touches au lieu d'être rassemblées dans un clavier pourraient être réparties différemment dans l'espace.

**Revendications**

1. Dispositif de commande par touches (1) du type dans lequel les touches (TIJ) ferment, lorsqu'elles sont pressées, un contact entre des conducteurs (LI, CJ) reliés aux entrées/sorties d'un micro-ordinateur (2) ou d'une logique câblée respectivement programmée ou agencée pour scruter les touches (TIJ), ces conducteurs étant constitués de M colonnes (CJ) et de N lignes (LI) aux intersections desquelles sont situées les touches et les contacts associés (TIJ), caractérisé en ce qu'au moins une colonne (C0 à C3) n'est reliée à une entrée/sortie (A0 à A3) que par une ligne (L0 à L3) avec interposition d'une diode (D0 à D3) entre la colonne et la ligne, l'intersection de cette colonne et de cette ligne ne comportant pas de touche et de contact associé (T00, T11, T22, T33).

2. Dispositif de commande par touches selon la revendication 1, caractérisé en ce qu'il comporte des moyens de rappel (R) de l'état logique des lignes (L0 à L3) reliées aux colonnes (C0 à C3) à un même état logique toujours le même en l'absence d'autre sollicitation.

3. Dispositif de commande par touches selon la revendication 2, caractérisé en ce que le programme de scrutation du micro-ordinateur (2) ou de la logique câblée comporte les phases suivantes :
— Configuration successive de chaque entrée/sortie (A0 à A3) dans la fonction (sortie) inhibant l'action des moyens de rappel (R) pour cette entrée/sortie, les autres entrées/sorties étant configurées dans la fonction inverse (entrée).
— Mise à 0 (ou à son complément) de la ligne <u>testée</u> et mémorisation de l'état logique (E3E2E1E0) des lignes.
— Comparaison de l'état mémorisé et de l'état correspondant à l'absence de touche enfoncée.
— Mémorisation du résultat (Z) de la comparaison.
— Si le résultat (Z) indique une touche enfoncée, établissement d'un code de l'état des touches et comparaison avec un tableau de codes valides.

4. Dispositif de commande par touches selon la revendication 3 caractérisé en ce qu'on utilise comme <u>code</u> de l'état des touches une combinaison $(\overline{E3E2E1E0}D3D2D1D0)$ de l'état mémorisé $(\overline{E3E2E1E0})$ et de l'état correspondant à l'absence de touche enfoncée (D3D2D1D0).

5. Dispositif de commande par touches selon la revendication 2 ou la revendication 3 caractérisé en ce qu'il comporte une colonne supplémentaire (C4) reliée à des moyens de rappel vers l'état logique opposé à l'état logique de rappel des lignes (L0 à L3).

6. Dispositif de commande par touches selon les revendications 3 et 5 caractérisé en ce que le programme de scrutation comporte une boucle préliminaire au cours de laquelle les entrées/sorties (A0 à A3) sont toutes configurées simultanément dans la fonction (sortie) inverse de celle inhibant l'action des moyens de rappel (R) puis mises à 0 (ou à son complément) pour tester les touches (T14) de la colonne supplémentaire C4.

7. Dispositif de commande par touches selon l'une quelconque des revendications 2 à 6 caractérisé en ce que les moyens de rappel de l'état logique des lignes sont constitués par des résistances (R) reliant les entrées/sorties (A0 à A3) à l'alimentation positive du micro-ordinateur (2) ou de la logique câblée.

8. Dispositif de commande par touches selon les revendications 5 et 7 caractérisé en ce que la colonne supplémentaire (C4) est reliée à la masse.

**Claims**

1. A keyboard device (1) of the kind in which the keys (TIJ), when they are pressed, close a contact between conductors (LI, CJ) connected to the inputs/outputs of a microcomputer (2) or of a logic circuit respectively programmed or arranged to scan the keys (TIJ), these conductors being formed by M columns (CJ) and N lines (LI) at the intersections of which are situated the keys and the associated contacts (TIJ), characterized in that at least one column (C0 to C3) is connected to an input/output (A0 to A3) only by one line (L0 to L3) with interpositioning of a diode (D0 to D3) between the column and the line, the intersection of this column and this line not comprising a key and associated contact (T00, T11, T22, T33).

2. A keyboard device according to claim 1, characterized in that it comprises means (R) for recalling the logic state of the lines (L0 to L3) connected to the columns (C0 to C3) to a same logic state always the same in the absence of another request.

3. A keyboard device according to claim 2, characterized in that the program for scanning the microcomputer (2) or the logic circuit comprises the following stages :
— Successive configuration of each input/output (A0 to A3) in the (output) function inhibiting the action of the recalling means (R) for this input/output, the other inputs/outputs being configured in the reverse (input) function.
— Reset to 0 (or to its complement) of the line tested and storage of the logic state (E3E2E1E0) of the lines.
— Comparison of the stored state and the state corresponding to the absence of a depressed key.
— Storage of the result (Z) of the comparison.
— If the result (Z) indicates a depressed key, a code for the state of the keys is established and compared with a table of valid codes.

4. A keyboard device according to claim 3, characterized in that a combination $(\overline{E3E2E1E0}D3D2D1D0)$ of the stored state $(\overline{E3E2E1E0})$ and of the state corresponding to the absence of a depressed key (D3D2D1D0) is utilised as a code for the state of the keys.

5. A keyboard device according to claim 2 or to claim 3, characterized in that it comprises a supplemental column (C4) connected to means for recall towards the logic state opposite to the logic state for recall of the lines (L0 to L3).

6. A keyboard device according to claims 3 and 5, characterized in that the scanning program comprises a preliminary loop during which the inputs/outputs (A0 to A3) are all simultaneously configured in the reverse (output) function compared to that inhibiting the action of the recalling means (R) and are then set to 0 (or to its complement) to test the keys (T14) of the supplemental column (C4).

7. A keyboard device according to any one of claims 2 to 6, characterized in that the means for recalling the logic state of the lines are formed by resistors (R) connecting the inputs/outputs (A0 to A3) to the positive supply of the microcomputer (2) or of the logic circuit.

8. A keyboard device according to claims 5 and 7, characterized in that the supplemental column (C4) is connected to earth.

**Patentansprüche**

1. Vorrichtung zur Steuerung mittels Tasten (1) derart, daß die Tasten (TIJ) dann, wenn sie gedrückt werden, einen Kontakt zwischen Leitern schließen, die mit den Eingängen/Ausgängen eines Mikrocomputers (2) oder einer Verdrahtungslogik, die so programmiert bzw. aufgebaut sind, daß sie die Tasten abfragen, verbunden sind, wobei die Leiter aus M Spalten (CJ) und N Reihen (LI) gebildet sind, an deren Schnittpunkten die Tasten und die zugehörigen Kontakte (TIJ) angeordnet sind, dadurch gekennzeichnet, daß wenigstens eine Spalte (C0 bis C3) mit einem Eingang/Ausgang (A0 bis A3) nur durch eine Zeile unter Zwischenschaltung einer Diode (D0 bis D3) zwischen die Spalte und die Zeile verbunden ist, wobei der Schnittpunkt dieser Spalte · mit dieser Zeile keine Taste und keinen zugehörigen Kontakt (T00, T11, T22, T33) aufweist.

2. Vorrichtung zur Steuerung mittels Tasten gemäß Anspruch 1, dadurch gekennzeichnet, daß sie Einrichtungen zum Rückstellen (R) des logischen Zustandes der mit den Spalten (C0 bis C3) verbundenen Zeilen (L0 bis L3) auf denjenigen logischen Zustand, der sich bei Abwesenheit einer weiteren Belastung stets einstellt, aufweist.

3. Vorrichtung zur Steuerung mittels Tasten gemäß Anspruch 2, dadurch gekennzeichnet, daß das Abfrageprogramm des Mikrocomputers (2) oder der Verdrahtungslogik die folgenden Schritte aufweist :
— aufeinanderfolgende Ausbildung eines jeden Eingangs/Ausgangs (A0 bis A3) zu einer Funktion (Ausgang), die die Betätigung der Rückstelleinrichtungen (R) für diesen Eingang/Ausgang hemmt, wobei die jeweils anderen Eingänge/Ausgänge zur umgekehrten Funktion (Eingang) ausgebildet werden ;
— Setzen der geprüften Zeile auf 0 (oder auf ihr Komplement) und Speicherung des logischen Zustandes ($\overline{E3E2E1E0}$) der Zeilen ;
— Vergleich des gespeicherten Zustandes mit dem Zustand, der dem Nichtvorliegen einer gedrückten Taste entspricht ;
— Speicherung des Ergebnisses (Z) des Vergleichs ;
— Erstellung eines Zustandscodes der Tasten und Vergleich mit einer Tabelle der gültigen Codes, falls das Ergebnis (Z) eine gedrückte Taste anzeigt.

4. Vorrichtung zur Steuerung mittels Tasten gemäß Anspruch 3, dadurch gekennzeichnet, daß als Zustandscode der Tasten eine Kombination ($\overline{E3E2E1E0}D3D2D1D0$) aus dem gespeicherten Zustand ($\overline{E3E2E1E0}$) und aus dem dem Nichtvorliegen einer gedrückten Taste entsprechenden Zustand (D3D2D1D0) verwendet wird.

5. Vorrichtung zur Steuerung mittels Tasten gemäß Anspruch 2 oder Anspruch 3, dadurch gekennzeichnet, daß sie eine zusätzliche Spalte (C4) aufweist, die mit Einrichtungen zum Rückstellen auf einen logischen Zustand, der dem logischen Zustand beim Rückstellen der Zeilen (L0 bis L3) entgegengesetzt ist, verbunden ist.

6. Vorrichtung zur Steuerung mittels Tasten gemäß den Ansprüchen 3 und 5, dadurch gekennzeichnet, daß das Abfrageprogramm eine einleitende Schleife aufweist, in deren Verlauf alle Eingänge/Ausgänge (A0 bis A3) gleichzeitig zu der Funktion (Ausgang) ausgebildet werden, die der die Betätigung der Rückstelleinrichtungen (R) verhindernden Funktion entgegengesetzt ist, und dann auf 0 (oder auf deren Komplement) gesetzt werden, um die Tasten (TI4) der zusätzlichen Spalte (C4) zu prüfen.

7. Vorrichtung zur Steuerung mittels Tasten gemäß einem der Ansprüche 2 bis 6, dadurch gekennzeichnet, daß die Einrichtungen zum Rückstellen des logischen Zustandes der Zeilen durch Widerstände (R) aufgebaut werden, die die Eingänge/Ausgänge (A0 bis A3) mit der positiven Versorgungsspannung des Mikrocomputers (2) oder der Verdrahtungslogik verbinden.

8. Vorrichtung zur Steuerung mittels Tasten gemäß den Ansprüchen 5 und 7, dadurch gekennzeichnet, daß die zusätzliche Spalte (C4) mit Masse verbunden ist.

FIG:1

FIG: 2

FIG:4

FIG:5

|  | C4 | CO | C1 | C2 | C3 |
|---|---|---|---|---|---|
| LO | O |  | 1 | 2 | 3 |
| L1 | 5 | 4 |  | 6 | 7 |
| L2 | A | 8 | 9 |  | B |
| L3 | F | C | D | E |  |

## FIG:3

| TIJ | $ | PORTA | DDRA |
|---|---|---|---|
| TO4 | O | 0001 | 0000 |
| TO1 | 1 | 0011 | 0001 |
| TO2 | 2 | 0101 | 0001 |
| TO3 | 3 | 1001 | 0001 |
| T10 | 4 | 0011 | 0010 |
| T14 | 5 | 0010 | 0000 |
| T12 | 6 | 0110 | 0010 |
| T13 | 7 | 1010 | 0010 |
| T20 | 8 | 0101 | 0100 |
| T21 | 9 | 0110 | 0100 |
| T24 | A | 0100 | 0000 |
| T23 | B | 1100 | 0100 |
| T30 | C | 1001 | 1000 |
| T31 | D | 1010 | 1000 |
| T32 | E | 1100 | 1000 |
| T34 | F | 1000 | 0000 |

## FIG:6

4